# EUROPÄISCHE PATENTSCHRIFT

(11) **EP 0 714 565 B1**
(45) Veröffentlichungstag und Bekanntmachung des Hinweises auf die Patenterteilung: **14.05.1997**
(21) Anmeldenummer: 94922167.5
(22) Anmeldetag: 12.08.1994
(51) Int. Cl.: H02H 7/06

(54) **ANORDNUNG ZUR ERFASSUNG VON STÄNDERERDSCHLÜSSEN BEI DREHSTROMMASCHINEN**
ARRANGEMENT FOR DETECTING STATOR EARTH LEAKAGES IN THREE-PHASE CURRENT MACHINES
SYSTEME DE DETECTION DE FUITE A LA TERRE DE STATOR DANS DES MACHINES TRIPHASEES

(30) Priorität: 19.08.1993 AT 16639/39
(43) Veröffentlichungstag der Anmeldung: 05.06.1996
(73) Patentinhaber: ELIN ENERGIEVERSORGUNG GESELLSCHAFT m.b.H., 1141 Wien (AT)
(72) Erfinder: STROBL, Jörg, A-2380 Perchtoldsdorf (AT)
(74) Vertreter: Krause, Peter
(86) Internationale Anmeldenummer: AT9400114
(87) Internationale Veröffentlichungsnummer: WO9505695

(56) Entgegenhaltungen:
- DE-A- 2 002 777

## Beschreibung

Die Erfindung betrifft eine Anordnung zur Erfassung von Ständererdschlüssen bei Drehstrommaschinen, insbesondere Synchrongeneratoren, wobei der Sternpunkt der Ständerwicklung über die Primärwicklung eines Spannungswandlers geerdet ist, und an die Klemmen der Drehstrommaschine ein Drehstromtransformator angeschlossen ist, dessen in Stern geschaltete Primärwicklung ebenfalls geerdet ist. Eine solche Anordnung ist aus der DE-A-2 002 777 bekannt.

Ständererdschlußschutzeinrichtungen sind bereits bekannt.

Eine gängige Ausführung verwendet einen an die Maschinenklemmen angeschlossenen Transformator zur Erzeugung einer künstlichen Spannungsverlagerung. Diese wird in der Regel durch ungleiche Anzapfungen des Transformators in den einzelnen Phasen erzielt.

Es ist auch bekannt, eine Verlagerung des Potentials des Sternpunktes der Maschine gegen Erde durch einprägen einer Spannung auf den primärseitigen Sternpunkt eines an den Maschinenklemmen angeschlossenen Drehstromtransformators zu erzielen.

Darüberhinaus ist aus der AT-PS 326 206 eine Einrichtung zum Schutz der Ständerwicklung von Synchrongeneratoren in Blockschaltung gegen Erdschlüsse bekannt, welche einen angenähert linearen Widerstand zwischen Ständerwicklung und Erde verwendet. Dieser Widerstand kann unmittelbar galvanisch oder über Transformatoren auf der Sternpunktseite oder der Klemmenseite angekoppelt sein, wobei diese Ankopplung durch beispielsweise einen Niederspannungsleistungsschalter auftrennbar ist. Dieses Schaltorgan befindet sich im Sekundärkreis eines Transformators über dessen Primärwicklung eine Verbindung zwischen Ständerwicklung und Erde verläuft.

Die obigen Einrichtungen weisen jedoch alle den Nachteil auf, daß sie trotz hoher Kosten vertreten werden müssen, da bei einem Ständererdschluß ohne diese Einrichtungen, der Schaden nicht mehr begrenzt werden könnte.

Es sind aus IEEE Transactions on Power Apperatus, Vol. PAS-103, No. 4, April 1984, "A comparison of 100% stator ground fault protection schemes for generator stator winding" von J.W.Pope und IEEE Transactions on Power Delivery, Vol. PWRD-1, No. 4, October 1986, Design principles of a new generator stator ground relay for 100% coverage of the stator winding" von R.J.Marttila auch bereits Anordnungen bekannt, bei welchen die dritte Harmonische in der Spannung zwischen Sternpunkt und Erde und/oder in den Spannungen zwischen Maschinenklemmen und Erde erfaßt und als Kriterium für das Vorliegen eines Ständererdschlusses herangezogen wird. Dieses Prinzip eignet sich besonders zur Erfassung von Erdschlüssen in Sternpunktsnähe der Drehstrommaschine. Solche Erdschlüsse können ansonsten nur mit einer der oben beschriebenen aufwendigen Anordnungen mit künstlicher Sternpunktverlagerung detektiert werden.

Jene Erdschlüsse, die sich nicht in der Nähe des Sternpunktes befinden werden in der Regel durch Messung der im wesentlichen aus der Grundwelle bestehenden Spannung zwischen Sternpunkt und Erde oder durch Messung des ebenfalls im wesentlichen aus der Grundwelle bestehenden Nullsystems der Klemmenspannung an einer offenen Dreieckswicklung eines Spannungswandlersatzes erfaßt.

Zum Ableiten des Störstromes, der über die Koppelkapazität des Blocktransformators bei Erdschlüssen im Netz zur Maschine fließt, und zum Dämpfen von Schwingungen bei transienten Vorgängen wird in den bisherigen Ausführungen der Ständererdschlußerfassung mit der dritten Harmonischen im Sternpunkt der Drehstrommaschine, gegebenenfalls über einen Transformator ein ohmscher Widerstand gegen Erde angeordnet. Die beiden vorgenannten Effekte beeinträchtigen nämlich die Funktion des mit der Grundwelle arbeitenden Erdschlußschutzes und sollen durch den Widerstand verringert werden. Der Widerstand beeinträchtigt widerum die Erfassung der dritten Harmonischen, da er selbst einen Erdschluß in Sternpunktsnähe darstellt, und somit der Eintritt eines echten Erdschlusses sich von dem vorher bestehendem Zustand nicht mehr stark unterscheidet.

Der DE-A 2 002 777 ist eine Anordnung zur Erfassung von Ständererdschlüssen bei Drehstrommaschinen zu entnehmen, deren Funktion auf dem Vergleich von dritten harmonischen Spannungen beruht. Der Sternpunkt der Ständerwicklung ist hier direkt über die Primärwicklung eines Spannungswandlers geerdet, dessen Sekundärwicklung mit einem komplexen Widerstand und Erfassungselementen in Serienschaltung verbunden ist. An die Klemmen der Drehstrommaschine ist ein Drehstromtransformator angeschlossen, dessen in Stern geschaltete Primärwicklung ebenfalls geerdet ist. Die zu einem offenen Dreieck geschaltete Sekundärwicklung des Drehstromtransformators ist mit einer Reihenschaltung aus einem zweiten komplexen Widerstand und den Erfassungselementen abgeschlossen. Die richtige Auslegung der beiden Widerstände ist für das einwandfreie und korrekte Ansprechen der Erfassungselemente bei einem Ständererdschluß unbedingt notwendig. Jedoch entsprechende Hinweise zur Dimensionierung dieser Widerstände sind in dieser Druckschrift nicht angegeben und dem Durchschnittsfachmann auch sicher nicht geläufig.

Die Aufgabe der Erfindung besteht nun darin, einen deutlichen Unterschied in der dritten Harmonischen im fehlerfreien und im erdschlußbehafteten Zustand festzustellen und trotzdem den oben erwähnten Störstrom ableiten und die Schwingungen dämpfen zu können.

Diese wird durch die Erfindung gelöst, welche dadurch gekennzeichnet ist, daß die Sekundärwicklung des Spannungswandlers mit einem Eingang eines Erdschlußrelais verbunden ist, und daß in die Erdleitung der Primärwicklung des Drehstromtransformators die Primärwicklung eines Einphasentransformators eingeschleift ist und die Sekundärwicklung dieses Einphasentransformators parallel einen Widerstand aufweist, der an einen zweiten Eingang des Erdschlußrelais angeschlossen ist, und daß der auf die Primärseite des Drehstromtransformators bezogene Leitwert des Widerstandes mindestens in der Größenordnung des Grundwellen-Leitwertes der Kapazität der Ständerwicklung der Drehstrommaschine gegen Erde ist.

Der besondere Vorteil der Erfindung liegt darin, daß im Sternpunkt der Drehstrommaschine keine nennenswerte Last gegen Erde vorgesehen ist, wodurch ein Erdschluß in Sternpunktsnähe in der dritten Harmonischen einen deutlichen Unterschied zum Normalbetrieb hervorruft. Durch den Widerstand werden auch die über den Transformator kommenden Störströme abgeleitet sowie Schwingungen gegen Erde gedämpft. Durch den Belastungswiderstand im Nullsystem der Klemmenspannung ist der Unterschied in der dritten Harmonischen zwischen erdschlußfreiem Zustand und Erdschluß in Sternpunktsnähe sehr groß. Bei dieser Art der Anordnung ist nämlich die dritte Harmonische im Null system der Klemmen spannungen im erdschlußfreien Zustand niedrig. Tritt jedoch in Sternpunktnähe ein Erdschluß auf, so ist die dritte Harmonische in diesem Nullsystem nahezu die ganze von der Maschine als Spannungsquelle mit geringem Innenwiderstand erzeugte dritte Harmonische. Sie ist somit praktisch eine starre Spannung und bricht durch Belastung mit dem Widerstand nicht ein.
Die Aufteilung der dritten Harmonischen zwischen Sternpunkt und Klemmenseite wird immer günstiger je niederohmiger der Widerstand ist. Im gleichen Maß steigt auch sein Vermögen der Störstromableitung und der Schwingungsdämpfung.
Der Widerstand als nennenswerte Belastungsimpedanz mindert im fehlerfreien Zustand die Nullspannung auf der Klemmenseite und hebt zugleich die Sternpunktsspannung an.

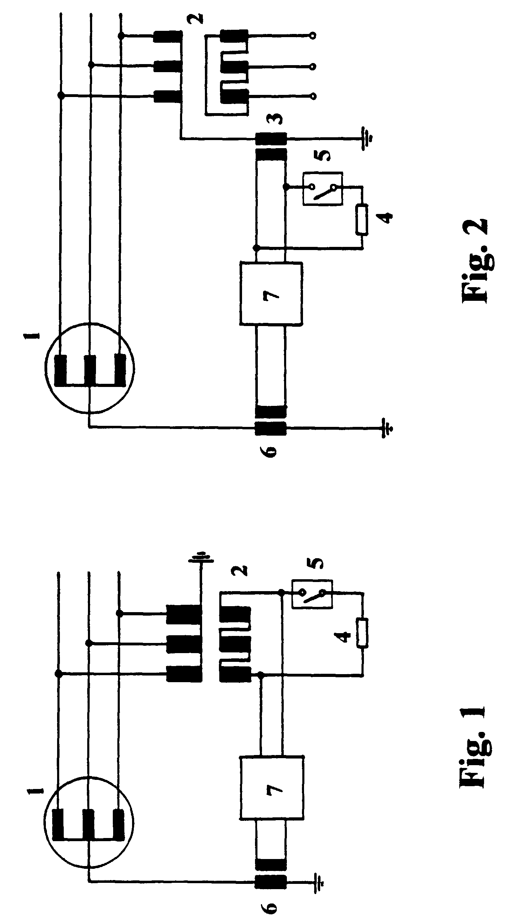

Die Erfindung wird nachstehend anhand der Zeichnung noch näher erläutert, wobei Fig. 1 eine größtenteils bekannte Anordnung zur Ständererdschlußerfassung zeigt und in Fig. 2 die erfindungsgemäße Schaltung zur Ständererdschlußerfassung dargestellt ist.

In Fig. 1 ist an die Klemmen einer Drehstrommaschine 1, welche z.B. ein Synchrongenerator ist, ein Drehstromtransformator 2 angeschlossen. Dieser muß einen freien magnetischen Rückschluß aufweisen um bei Erdschluß der Drehstrommaschine 1 eine Nullspannung zu übertragen, wodurch nur ein Fünfschenkeltransformator oder eine Transformatorbank geeignet ist. Die Primärwicklung des Transformators 2 ist in Stern geschaltet, wobei der Sternpunkt geerdet ist. Die Sekundärwicklung des Transformators 2 ist zu einem offenen Dreieck geschaltet und mit dem Widerstand 4 belastet, der mit dem in Serie angeordneten Schalter 5 abgeschaltet werden kann. Am Sternpunkt der Drehstrommaschine 1 ist ein Spannungswandler 6 angeschlossen. Die Sekundärspannung dieses Wandlers 6, und die Spannung an der offenen Dreieckswicklung wird einem statischen Erdschlußrelais 7 zugeführt, das entsprechend der Größe und Phasenlage der dritten Harmonischen in diesen Spannungen einen Erdschluß im Generator 1 erfaßt.

In Fig. 2 ist an den geerdeten Sternpunkt des Transformators 2 ein Einphasentransformator 3 angeschlossen. An der Sekundärseite des Transformators 3, die mit dem Erdschlußrelais 7 verbunden ist, liegt der Widerstand 4 mit dem Schalter 5 in Serie. In diesem Fall ist beim Transformator 2 kein freier magnetischer Rückschluß erforderlich da die Nullspannung vom Transformator 3 übertragen wird. Die Schaltgruppe des Transformators 2 muß jedoch den Durchgang eines Nullstromes ermöglichen, wozu die Schaltgruppen Yd oder Zy geeignet sind.

## Patentansprüche

1. Anordnung zur Erfassung von Ständererdschlüssen bei Drehstrommaschinen (1), insbesondere Synchrongeneratoren, wobei der Sternpunkt der Ständerwicklung über die Primärwicklung eines Spannungswandlers (6) geerdet ist, und an die Klemmen der Drehstrommaschine ein Drehstromtransformator (2) angeschlossen ist, dessen in Stern geschaltete Primärwicklung ebenfalls geerdet ist, **dadurch gekennzeichnet**, daß die Sekundärwicklung des Spannungswandlers (6) mit einem Eingang eines Erdschlußrelais (7) verbunden ist, und daß in die Erdleitung der Primärwicklung des Drehstromtransformators (2) die Primärwicklung eines Einphasentransformators (3) eingeschleift ist und die Sekundärwicklung dieses Einphasentransformators (3) parallel einen Widerstand (4) aufweist, der an einen zweiten Eingang des Erdschlußrelais (7) angeschlossen ist, und daß der auf die Primärseite des Drehstromtransformators (2) bezogene Leitwert des Widerstandes (4) mindestens in der Größenordnung des Grundwellen-Leitwertes der Kapazität der Ständerwicklung der Drehstrommaschine (1) gegen Erde ist.

## Claims

1. An arrangement for detecting ground losses in three-phase machines (1), especially in synchronous generators, with the stator winding neutral being grounded through the primary winding of a voltage transformer (6), and a three-phase transformer (2), the wye primary winding of which is also grounded, being connected to the three-phase machine terminals, **characterized in that** the secondary winding of said voltage transformer (6) is connected to an input of a grounding relay (7), and in that the primary winding of a one-phase autotransformer (3) is arranged in the grounding conductor loop of said three-phase transformer (2) primary winding, and the secondary winding of said one-phase autotransformer (3) parallely includes a resistor (4) connected to a second input of said grounding relay (7), and in that resistor (4) susceptance, as referred to said three-phase transformer (2) primary side is at least equal to an order of magnitude of the direct wave susceptance of the stator winding capacity of said three-phase machine (1) with respect to the ground.

## Revendications

1. Agencement de détection de fuites à la terre dans des machines triphasées (1), notamment des génératrices synchrones, le point neutre de l'enroulement de stator étant mis à la terre par l'intermédiaire de l'enroulement primaire d'un transformateur de tension (6), et un transformateur triphasé (2) dont l'enroulement primaire monté en étoile est également mis à la terre, étant raccordé aux bornes de la machine triphasée, caractérisé en ce que l'enroulement secondaire du transformateur de tension (6) est relié à une entrée d'un relais de mise à la terre (7), et en ce que l'enroulement primaire d'un autotransformateur monophasé (3) est monté dans la boucle du conducteur de mise à la terre de l'enroulement primaire du transformateur triphasé (2), et l'enroulement secondaire de cet autotransformateur monophasé (3) présente, en parallèle, une résistance (4) raccordée à une second entrée du relais de mise à la terre (7), et en ce que la susceptance de la résistance (4), rapportée au côté primaire du transformateur triphasé (2) est au moins de l'ordre de grandeur de la susceptance d'onde directe de la capacité de l'enroulement de stator de la machine triphasée (1) par rapport à la terre.
